# EUROPEAN PATENT APPLICATION

(11) **EP 2 458 644 A1**
(43) Date of publication of application: **30.05.2012**
(21) Application number: 10833189.3
(22) Date of filing: 24.11.2010
(51) Int. Cl.: H01L 31/04, C23C 16/24, H01L 21/205, H01L 27/146

(54) **PHOTOELECTRIC CONVERTER AND METHOD FOR PRODUCING SAME**

(30) Priority: 30.11.2009 JP 2009272011; 12.11.2010 JP 2010253550
(71) Applicant: Sanyo Electric Co., Ltd., Osaka 570-8677 (JP)
(72) Inventor: KUNII Toshie, Moriguchi-shi Osaka 570-8677 (JP); MATSUMOTO Mitsuhiro, Moriguchi-shi Osaka 570-8677 (JP)
(74) Representative: Metzler, Volker
(86) International application number: PCT/JP2010/070853
(87) International publication number: WO 2011/065343

(57) **Abstract**

A photoelectric conversion device is provided wherein variance of photoelectric conversion efficiency within a panel plane is reduced. A method of manufacturing a photoelectric conversion device having a microcrystalline silicon photoelectric conversion unit (104) which has a layered structure including a p-type layer (40), an i-type layer (42) including a microcrystalline silicon layer which serves as a power generating layer, and an n-type layer (44) is provided, the method comprising a step of forming the i-type layer (42), wherein a first i-type layer (42a) is formed and a second i-type layer (42b) is formed over the first i-type layer (42a) under a condition that a crystallization percentage is higher than that of the first i-type layer (42a) and an in-plane distribution of the crystallization percentage is lower than that of the first i-type layer.

## Description

### TECHNICAL FIELD

The present invention relates to a photoelectric conversion device and a manufacturing method thereof.

### BACKGROUND ART

Solar cells which use polycrystalline or microcrystalline or amorphous silicon as a photoelectric conversion layer are known. In particular, photoelectric conversion devices having a structure in which thin films of microcrystalline or amorphous silicon are layered have attracted much attention from the viewpoints of resource consumption, cost reduction, and improved efficiency.

In general, a photoelectric conversion device is formed by sequentially layering, over a substrate having an insulating surface, a first electrode, a photoelectric conversion cell made of semiconductor thin films, and a second electrode. The photoelectric conversion cell is formed by layering, from the side of incidence of light, a p-type layer, an i-type layer, and an n-type layer. As a method of improving a conversion efficiency of the photoelectric conversion device, a method is known in which two or more types of photoelectric conversion cells are layered in the direction of incidence of light. In this case, for example, a first photoelectric conversion unit including a photoelectric conversion layer with a wide bandgap is placed on a side, of the photoelectric conversion device, of the incidence of light, and then a second photoelectric conversion unit including a photoelectric conversion layer with a narrower bandgap than the first photoelectric conversion unit is placed. With such a configuration, photoelectric conversion is enabled over a wide range of wavelengths of the incident light, and the conversion efficiency of the overall device can be improved. For example, a structure is known in which an amorphous silicon (a-Si) photoelectric conversion unit is employed as a top cell and a microcrystalline silicon (µc-Si) photoelectric conversion unit is employed as a bottom cell.

The µc-Si photoelectric conversion unit in which microcrystalline silicon including a microcrystalline phase is used as the i-type layer which is a power generating layer has an advantage of superior light stability compared to the amorphous silicon, but also has a disadvantage that there are more deficiencies in the film due to dangling bonds or the like. Therefore, a technique has been considered to improve the conversion efficiency of a photovoltaic force by varying a crystallization percentage of silicon and hydrogen content in the i-type layer along the thickness direction (for example, refer to Patent Literature 1).

### [Related Art References]

### [Patent Literature]

[Patent Literature 1] Japanese Patent No. 3679595

### DISCLOSURE OF INVENTION

### [Technical Problem]

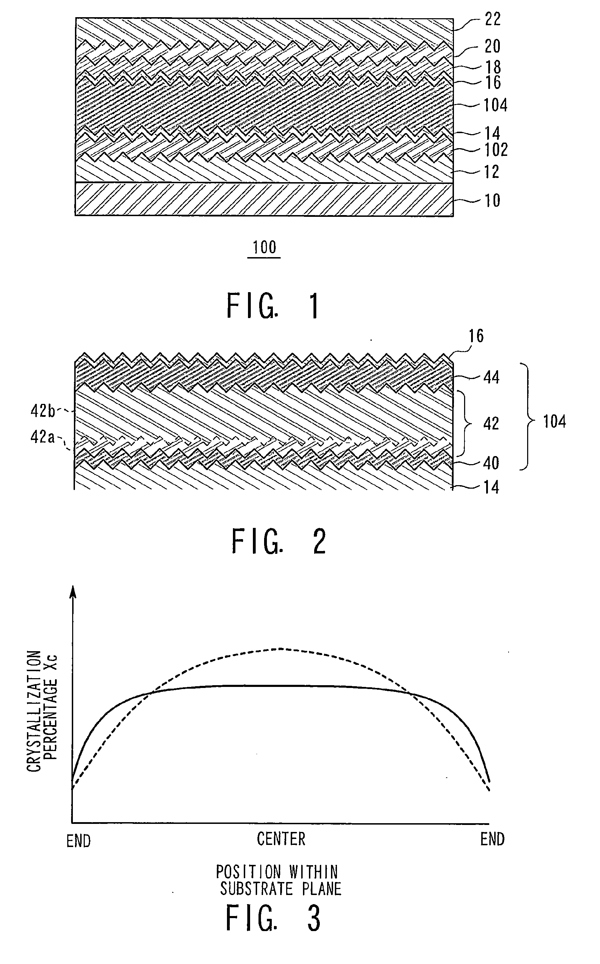

When a microcrystalline silicon thin film is formed, the ratio between a crystalline phase and an amorphous phase (crystallization percentage) in the film can be varied by adjusting film formation conditions. When the i-type layer of the microcrystalline silicon is formed over the p-type layer, if a film is formed under the conditions that a microcrystalline silicon thin film with a high crystallization percentage is formed near a center of a panel of the photoelectric conversion device, as shown by a broken line in FIG. 3, variance of the crystallization percentage within the panel plane of the photoelectric conversion device is increased. Consequently, a photoelectric conversion cell having a high crystallization percentage and a high photoelectric conversion efficiency near the center of the panel can be obtained, but only a photoelectric conversion cell having a low crystallization percentage and a low photoelectric conversion efficiency can be obtained near an end of the panel. As a result, there is a disadvantage that the conversion efficiency of the panel of the photoelectric conversion device as a whole is reduced.

### [Solution to Problem]

According to one aspect of the present invention, there is provided a method of manufacturing a photoelectric conversion device having a layered structure of a p-type layer, an i-type layer including a microcrystalline silicon layer which serves as a power generating layer, and an n-type layer, the method comprising the step of forming the i-type layer wherein a first microcrystalline silicon layer is formed, and a second microcrystalline silicon layer is formed over the first microcrystalline silicon layer under a condition that a crystallization percentage is higher than that of the first microcrystalline silicon layer and an in-plane distribution of the crystallization percentage is lower than that of the first microcrystalline silicon layer.

According to another aspect of the present invention, there is provided a photoelectric conversion device having a layered structure of a p-type layer, an i-type layer including a microcrystalline silicon layer which serves as a power generating layer, and an n-type layer, wherein the i-type layer has a layered structure of a first microcrystalline silicon layer and a second microcrystalline silicon layer formed under a condition that a crystallization percentage is higher than that of the first microcrystalline silicon layer and an in-plane distribution of the crystallization percentage is lower than that of the first microcrystalline silicon layer.

### [Advantageous Effects of Invention]

According to various aspects of the present invention, variance of the photoelectric conversion efficiency within a panel plane in the photoelectric conversion device can be reduced.

### BRIEF DESCRIPTION OF DRAWINGS

FIG. 1 is a diagram showing a structure of a photoelectric conversion device in a preferred embodiment of the present invention.
FIG. 2 is a diagram showing a structure of a µc-Si unit of a photoelectric conversion device in a preferred embodiment of the present invention.
FIG. 3 is a diagram showing a distribution of a crystallization percentage of an i-type layer of a µc-Si unit in a preferred embodiment of the present invention.
FIG. 4 is a diagram showing characteristic measurement points of photoelectric conversion devices in Examples and Comparative Examples in the present invention.
FIG. 5 is a diagram showing a measurement result of a crystallization percentage of an i-type layer of a µc-Si unit in a preferred embodiment of the present invention.
FIG. 6 is a diagram showing another example structure of a µc-Si unit of a photoelectric conversion device in a preferred embodiment of the present invention.
FIG. 7 is a diagram showing a result of measurement of a distribution, within a plane of a substrate, of efficiency of a photoelectric conversion device in a preferred embodiment of the present invention.
FIG. 8 is a diagram showing a result of measurement of a distribution, within a plane of a substrate, of efficiency of a photoelectric conversion device in a preferred embodiment of the present invention.

### BEST MODE FOR CARRYING OUT THE INVENTION

FIG. 1 is a cross sectional diagram showing a structure of a photoelectric conversion device 100 in a preferred embodiment of the present invention. The photoelectric conversion device 100 in the present embodiment has a structure in which, with a transparent insulating substrate 10 as a side of incidence of light, a transparent conductive film 12, an amorphous silicon (s-Si) (photoelectric conversion) unit 102 having a wide bandgap and serving as a top cell, an intermediate layer 14, a microcrystalline silicon (µc-Si) (photoelectric conversion) unit 104 having a narrower bandgap than the α-Si unit 102 and serving as a bottom cell, a first backside electrode layer 16, a second backside electrode layer 18, a filling member 20, and a protective film 22 are layered from the side of incidence of light. Here, each of the α-Si unit 102 and the µc-Si unit 104 serves as a power generating layer of the photoelectric conversion device 100 in the preferred embodiment of the present invention.

A structure and a manufacturing method of the photoelectric conversion device 100 in the preferred embodiment of the present invention will now be described. As the photoelectric conversion device 100 in the preferred embodiment of the present invention is characterized by the i-type layer being included in the µc-Si unit 104, the i-type layer included in the µc-Si unit 104 will be described particularly in detail.

For the transparent insulating substrate 10, for example, a material having a light transmitting characteristic at least in a visible light wavelength range may be employed such as, for example, a glass substrate, a plastic substrate, etc. The transparent conductive film 12 is formed over the transparent insulating substrate 10. For the transparent conductive film 12, preferably, one or a combination of a plurality of transparent conductive oxides (TCO) in which tin oxide (SnO₂), zinc oxide (ZnO), indium tin oxide (ITO) or the like is doped with tin (Sn), antimony (Sb), fluorine (F), aluminum (Al) or the like is used. Inparticular, zincoxide (ZnO) is preferable as zinc oxide has a high light transmittance, a low resistivity, and a high plasma resistance. The transparent conductive film 12 may be formed, for example, through sputtering. A thickness of the transparent conductive film 12 is preferably in a range of greater than or equal to 0.5 µm and less than or equal to 5 µm. In addition, textured shape having a light confinement effect is preferably provided on a surface of the transparent conductive film 12.

Over the transparent conductive film 12, p-type, i-type, and n-type silicon-based thin films are sequentially layered, to form the α-Si unit 102. The α-Si unit 102 may be formed by plasma CVD in which plasma of mixture gas, in which silicon-containing gas such as silane (SiH₄), disilane (Si₂H₆), and dichlorsilane (SiH₂Cl₂), carbon-containing gas such as methane (CH₄), p-type dopant-containing gas such as diborane (B₂H₆), n-type dopant-containing gas such as phosphine (PH₃), and dilution gas such as hydrogen (H₂) are mixed, is formed, and a film is formed.

For the plasma CVD, for example, RF plasma CVD of 13.56 MHz is preferably applied. The RF plasma CVD may be of a parallel-plate type. Of the electrodes of the parallel-plate type, on a side where the transparent insulating substrate 10 is not provided, a gas shower hole for supplying mixture gas of the material may be formed. An input power density of plasma is preferably greater than or equal to 5 mW/cm² and less than or equal to 100 mW/cm².

In general, the p-type layer, the i-type layer, and the n-type layer are formed in separate film formation chambers. The film formation chamber may be vacuum-evacuated by a vacuum pump, and an electrode for the RFplasma CVD is built into the film formation chamber. In addition, a transporting device of the transparent insulating substrate 10, a power supply and a matching device for the RF plasma CVD, and pipes for supplying gas are provided.

The p-type layer is formed over the transparent conductive film 12. For the p-type layer, a p-type amorphous silicon layer (p-type α-Si:H) which is doped with a p-type dopant (such as boron) and which has a thickness of greater than or equal to 10 nm and less than or equal to 100 nm is employed. The film quality of the p-type layer can be varied by adjusting the mixture ratios of the silicon-containing gas, carbon-containing gas, p-type dopant-containing gas, and dilution gas, pressure, and plasma generating high-frequency power. For the i-type layer, an amorphous silicon film which is formed over the p-type layer, which is not doped, and which has a thickness of greater than or equal to 50 nm and less than or equal to 500 nm is employed. The film quality of the i-type layer can be varied by adjusting the mixture ratio of the silicon-containing gas and the dilution gas, pressure, and plasma generating high-frequency power. In addition, the i-type layer serves as the power generating layer of the α-Si unit 102. For the n-type layer, an n-type amorphous silicon layer (n-type α-Si:H) or an n-type microcrystalline silicon layer (n-type µc-Si:H) which is formed over the i-type layer, which is doped with an n-type dopant (such as phosphorus), and which has a thickness of greater than or equal to 10 nm and less than or equal to 100 nm, is employed. The film quality of the n-type layer may be varied by adjusting the mixture ratios of the silicon-containing gas, carbon-containing gas, n-type dopant-containing gas, and dilution gas, pressure, and plasma generating high-frequency power.

The intermediate layer 14 is formed over the α-Si unit 102. For the intermediate layer 14, a transparent conductive oxide (TCO) such as zinc oxide (ZnO) and silicon oxide (SiOx) is preferably employed. In particular, zinc oxide (ZnO) or silicon oxide (SiOx) doped with magnesium (Mg) is preferably employed. The intermediate layer 14 may be formed, for example, through sputtering. A thickness of the intermediate layer 14 is preferably in a range of greater than or equal to 10 nm and less than or equal to 200 nm. Alternatively, it is also possible to not provide the intermediate layer 14.

As shown in an enlarged cross sectional diagram of FIG. 2, over the intermediate layer 14, the µc-Si unit 104 in which a p-type layer 40, an i-type layer 42, and an n-type layer 44 are sequentially layered is formed. The µc-Si unit 104 can be formed through plasma CVD in which a plasma of mixture gas, in which silicon-containing gas such as silane (SiH₄), disilane (Si₂H₆), and dichlorosilane (SiH₂Cl₂), carbon-containing gas such as methane (CH₄), p-type dopant-containing gas such as diborane (B₂H₆), n-type dopant-containing gas such as phosphine (PH₃), and dilution gas such as hydrogen (H₂) are mixed, is formed, and a film is formed.

As the plasma CVD, for example, RF plasma CVD or VHF plasma CVD is preferably applied. The RF plasma CVD and the VHF plasma CVD may be of a parallel-plate type. Of the electrodes of the parallel-plate type, on a side where the transparent insulating substrate 10 is not provided, a gas shower hole for supplying mixture gas of the materials may be provided. An input power density of plasma is preferably greater than or equal to 5 mW/cm² and less than or equal to 1000 mW/cm².

The p-type layer 40 is formed over the intermediate layer 14 or the n-type layer of the a-Si unit 102. For the p-type layer 40, a p-type microcrystalline silicon layer (p-type µc-Si:H) doped with a p-type dopant (such as boron) and having a thickness of greater than or equal to 5 nm and less than or equal to 50 nm is employed. The film quality of the p-type layer 40 can be varied by adjusting the mixture ratios of the silicon-containing gas, carbon-containing gas, p-type dopant-containing gas, and dilution gas, pressure, and plasma generating high-frequency power. For the i-type layer 42, a microcrystalline silicon film formed over the p-type layer 40, not doped with any dopant, and having a thickness of greater than or equal to 0.5 µm and less than or equal to 5 µm, is employed. The details of the i-type layer 42 will be described later. The n-type layer 44 is formed over the i-type layer 42. For the n-type layer 44, an n-type microcrystalline silicon layer (n-type µc-Si:H) doped with an n-type dopant (such as phosphorus) and having a thickness of greater than or equal to 5 nm and less than or equal to 50 nm is employed. However, the µc-Si unit 104 is not limited to the above-described structure, and other structures may be employed so long as the i-type microcrystalline silicon layer (i-type µc-Si:H) to be described below is employed as the power generating layer.

In the present embodiment, the i-type layer 42 is formed under at least two different film formation conditions. On the side nearer to the p-type layer, a first i-type layer 42a is formed under a film formation condition that the crystallization percentage Xc is low near the center within the plane of the substrate when the film is formed as a single film over a glass substrate or the like and, as shown with a solid line in FIG. 3, the uniformity of the crystallization percentage Xc within the plane of the substrate is high. The crystallization percentage Xc of the first i-type layer 42a is preferably about 2 ∼ 4 when the layer is formed as a single film of approximately 500 nm. On the other hand, on the side further away from the p-type layer than the first i-type layer 42a, a second i-type layer 42b is formed under film formation conditions in which the crystallization percentage Xc is higher than that of the first i-type layer 42a near the center within the plane of the substrate when the film is formed as a single film over a glass substrate, and, as shown by a broken line in FIG. 3, the uniformity of the crystallization percentage Xc within the plane of the substrate is lower than that of the first i-type layer 42a. The crystallization percentage Xc of the second i-type layer 42b is preferably about 4 ∼ 6 when the layer is formed as a single film of approximately 500 nm.

The first i-type layer 42a is preferably formed by plasma film formation while introducing mixture gas having a silane (SiH₄) /hydrogen (H₂) ratio of greater than or equal to 0.005 and less than or equal to 0.1, at a pressure of greater than or equal to 1330 Pa and less than or equal to 4000 Pa. As the plasma film formation, VHF plasma film formation of a frequency of greater than or equal to 13.56 MHz and less than or equal to 70 MHz is preferably employed. A substrate temperature during film formation is preferably greater than or equal to 160 °C and less than or equal to 230 °C, and an input power for the plasma is preferably greater than or equal to 0.05 W/cm² and less than or equal to 5 W/cm².

A thickness of the first i-type layer 42a is preferably greater than or equal to 100 nm and less than or equal to 2000 nm, and is more preferably greater than or equal to 500 nm and less than or equal to 1500 nm. A thickness of the second i-type layer 42b is preferably greater than or equal to 500 nm and less than or equal to 3000 nm, and is more preferably greater than or equal to 1000 nm and less than or equal to 2500 nm. When the thickness of the first i-type layer 42a is less than 100 nm, the advantage of reducing the variance of the photoelectric conversion efficiency within the panel plane cannot be obtained. When the thickness of the first i-type layer 42a is greater than 2500 nm or the thickness of the second i-type layer 42b is greater than 3500 nm, a total thickness of the first i-type layer 42a and the second i-type layer 42b becomes too large, and the photoelectric conversion efficiency may be reduced.

A layered structure of a reflective metal and a transparent conductive oxide (TCO) is formed as the first backside electrode layer 16 and the second backside electrode layer 18 over the µc-Si unit 104. For the first backside electrode layer 16, the transparent conductive oxide (TCO) such as tin oxide (SnO₂), zinc oxide (ZnO), and indium tin oxide (ITO) is employed. The TCO may be formed, for example, through sputtering or the like. For the second backside electrode layer 18, a metal such as silver (Ag) and aluminum (Al) may be employed. A total thickness of the first backside electrode layer 16 and the second backside electrode layer 18 is preferably about 1 µm. Textured shape for improving the light confinement effect is preferably formed on at least one of the first backside electrode layer 16 and the second backside electrode layer 18.

Further, with the filling member 20, the surface of the second backside electrode layer 18 is covered with the protective film 22. The filling member 20 and the protective film 22 may be made of a resin material such as EVA and polyimide. With this configuration, intrusion of moisture or the like to the power generating layer of the photoelectric conversion device 100 can be prevented.

With the use of a YAG laser (basic harmonic 1064 nm and second harmonic 532 nm), a separation andmachiningprocess of the transparent conductive film 12, the a-Si unit 102, the intermediate layer 14, the µc-Si unit 104, the first backside electrode layer 16, and the second backside electrode layer 18 may be executed, to obtain a structure in which a plurality of cells are connected in series.

### <Examples>

Examples and Comparative Examples of the present invention will now be described.

### <First Example>

As the transparent insulating substrate 10, a glass substrate having a size of 550 mm x 650 mm and a thickness of 4 mm was used. Over the transparent insulating substrate 10, a SnO₂ layer having a thickness of 600 nm and having textured shape over the surface thereof was formed through thermal CVD as the transparent conductive film 12. Then, the transparent conductive film 12 was patterned in a strip shape with the YAG laser. As the YAG laser, a YAG laser having a wavelength of 1064 nm, an energy density of 13 J/cm², and a pulse frequency of 3 kHz was used.

Next, the p-type layer, i-type layer, and n-type layer of the a-Si unit 102 were sequentially layered. The p-type layer, i-type layer, and n-type layer of the a-Si unit 102 were formed under film formation conditions shown in Table 1. Then, over the n-type layer of the a-Si unit 102, the µc-Si unit 104 was formed. The p-type layer 40, i-type layer 42, and n-type layer 44 of the µc-Si unit 104 were formed under the film formation conditions shown in Table 2. Here, with regard to diborane (B₂H₆) and phosphine (PH₃), gas flow rates of hydrogen-based concentration of 1% are shown. The i-type layer 42 was formed in a layered structure of the first i-type layer 42a which was formed under film formation conditions where the crystallization percentage Xc is low near the center within the plane of the substrate when the film was formed as a single film over a glass substrate or the like and the uniformity of the crystallization percentage Xc in the plane of the substrate is high, and the second i-type layer 42b which was formed under film formation conditions where the crystallization percentage Xc was higher than that of the first i-type layer 42a near the center within the plane of the substrate when the film was formed as a single film over the glass substrate, and the uniformity of the crystallization percentage Xc within the plane of the substrate was lower than that of the fist i-type layer 42a.

The thickness of the first i-type layer 42a was set at 1.5 µm, and the thickness of the second i-type layer 42b was set at 1.0 µm.

**[Table 1]**

| | LAYER | SUBSTRATE TEMPERATURE (C°) | GAS FLOW RATE (sccm) | REACTION PRESSURE (Pa) | RF power (kW) | THICKNESS (nm) |
|---|---|---|---|---|---|---|
| a-Si UNIT 102 | p-TYPE LAYER (p1); HIGH-ABSORPTION AMORPHOUS SILICON CARBIDE LAYER | 180 | SiH₄:75 CH₄:150 H₂:750 B₂H₆:23 | 80 | 56 (0.01W/cm²) | 7 |
| | p-TYPE LAYER (p2); LOW-ABSORPTION AMORPHOUS SILICON CARBIDE LAYER | 180 | SiH₄:75 CH₄:150 H₂:750 B₂H₆:2 | 80 | 56 (0.01W/cm²) | 3 |
| | BUFFER LAYER | 180 | SiH_{4:}38 CH4:19 H₂:3760 | 80 | 56 (0.01W/cm²) | 10 |
| | i-TYPE LAYER | 180 | SiH₄:600 H₂:2000 | 100 | 60 (0.012W/cm²) | 250 |
| | n-TYPE LAYER | 180 | SiH₄:20 H₂:4000 PH₃:10 | 200 | 600 (0.12W/cm²) | 20 |

**[Table 2]**

| | LAYER | SUBSTRATE TEMPERATURE (C°) | GAS FLOW RATE (sccm) | REACTION PRESSURE (Pa) | FREQUENCY | RF power (kW) | DISTANCE BETWEEN ELEC TRODES (mm) | THICKNESS (nm) |
|---|---|---|---|---|---|---|---|---|
| µc-Si UNIT 104 | p-TYPE LAYER 40 | 200 | SiH₄:25 H₂:5000 B₂H₆:5 | 106 | RF | 250 (0.05w/cm²) | 25 | 30 |
| | FIRST i-TYPE LAYER 42a | 180 | SiH₄:300 H₂:14000 | 9600 | VHF (27MH z) | 2500 (0.5W/cm²) | 6 | 1500 |
| | SECOND i-TYPE LAYER 42b | 180 | SiH₄:300 H₂:14000 | 11000 | VHF (27MH z) | 2500 (0.5W/cm²) | 7 | 1000 |
| | n-TYPE LAYER 44 | 200 | SiH₄:25 H₂:5000 PH₃:25 | 133 | RF | 1500 (0.3W/cm²) | 25 | 50 |

Then, a YAG laser was irradiated at a position on a side from the patterning position of the transparent conductive film 12 by 50 µm, to pattern the a-Si unit 102 and the µc-Si unit 104 in the strip shape. As the YAG laser, a YAG laser having an energy density of 0.7 J/cm² and a pulse frequency of 3 kHz was employed.

Next, a ZnO film was formed through sputtering as the first backside electrode layer 16, and a Ag electrode was formed through sputtering as the second backside electrode layer 18. Then, a YAG laser was irradiated at a position of 50 µm from the patterning position of the a-Si unit 102 and the µc-Si unit 104, to pattern the first backside electrode layer 16 and the second backside electrode layer 18 in a strip shape. For the YAG laser, a YAG laser having an energy density of 0.7 J/cm² and a pulse frequency of 4 kHz was employed.

### (Second Example)

Under film formation conditions similar to the above-described first Example, the thickness of the first i-type layer 42a was set to 1.0 µm and the thickness of the second i-type layer 42b was set to 1.5 µm.

### (First Comparative Example)

Under film formation conditions similar to the above-described first Example, the thickness of the first i-type layer 42a was set to 2.5 µm and the second i-type layer 42b was not formed.

### (Second Comparative Example)

Under film formation conditions similar to the above-described first Example, the first i-type layer 42a was not formed, and the thickness of the second i-type layer 42b was set to 2. 5 µm, to thereby form the second i-type layer 42b directly over the n-type layer of the a-Si unit 102.

### (Third Comparative Example)

The order of film formation of the first i-type layer 42a and the second i-type layer 42b was reversed from that in the above-described first Example. Namely, the second i-type layer 42b of a thickness of 1.0 µm was first formed over the n-type layer of the a-Si unit 102, and then, the first i-type layer 42a of a thickness of 1.5 µm was formed.

### (Fourth Comparative Example)

Similar to the third Comparative Example, the order of film formation for the first i-type layer 42a and the second i-type layer 42b was reversed. In addition, the thickness of the second i-type layer 42b was set to 1.5 µm and the thickness of the first i-type layer 42a was set to 1.0 µm.

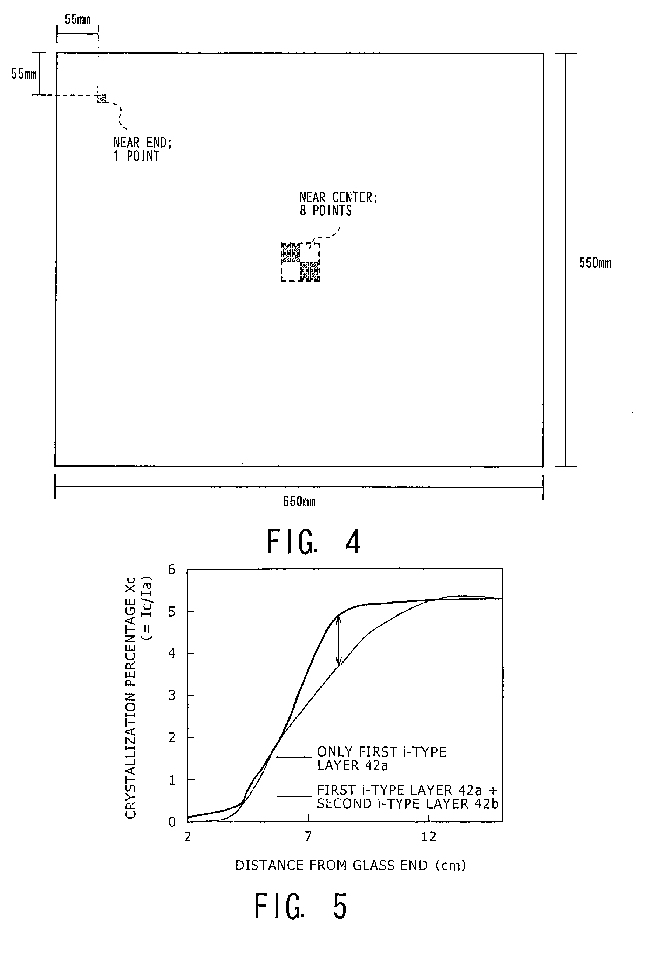

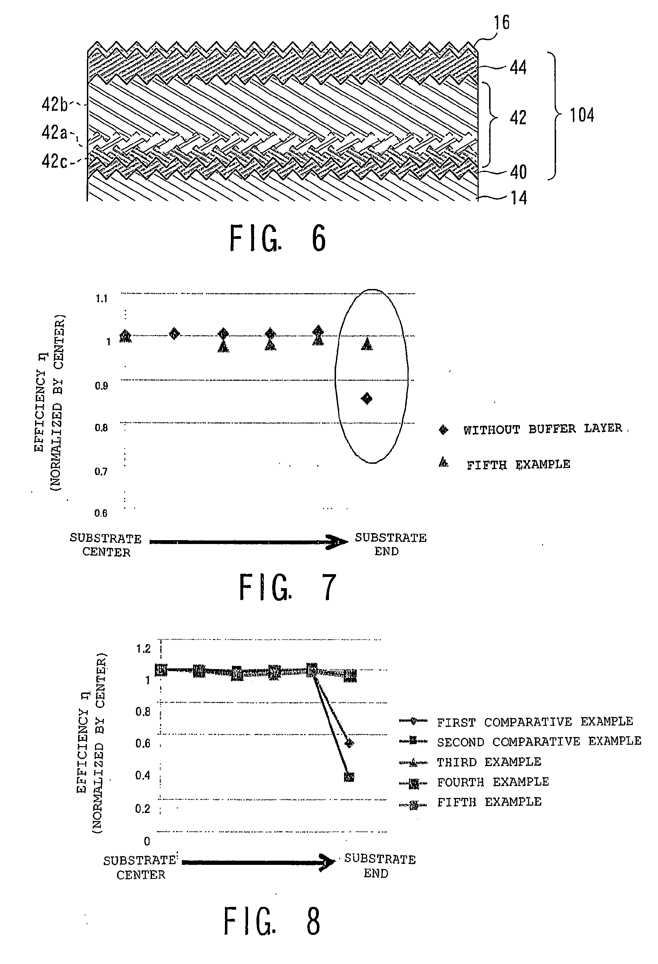

Table 3 shows open voltages Voc, short-circuit current densities Jsc, fill factors FF, and efficiencies η of the photoelectric conversion devices of the first and second Examples and the first through fourth Comparative Examples. For the photoelectric conversion measurement, as shown in FIG. 4, 8 points within a central area of 100 mmx 100mm in the panel plane of the photoelectric conversion device and one point at an inner position from the panel corner by 55 mm were measured. For the 8 center points within the panel plane, an average value was calculated, and the open voltage Voc, short-circuit current density Jsc, fill factor FF, and efficiency η are shown in a normalized state with the averages being 1.

**[Table 3]**

| | THICKNESS | | POSITION | OPEN VOLATAGE Voc(V) | SHORT-CIRCUITING CURRENT DENSITY Jsc (mA/cm²) | FF | EFFICIENCY η (%) |
|---|---|---|---|---|---|---|---|
| | FIRST i-TYPE LAYER 42a | SECOND i-TYPE LAYER 42B | | | | | |
| FIRST EXAMPLE | 1.5µm | 1.0µm | CENTER | 1 | 1 | 1 | 1 |
| | | | END | 1.008 | 0.986 | 0.996 | 0.989 |
| SECOND EXAMPLE | 1.0µm | 1.5µm | CENTER | 1 | 1 | 1 | 1 |
| | | | END | 1.007 | 0.907 | 1.04 | 0.95 |
| FIRST COMPARATIVE EXAMPLE | 2.5µm | 0 | CENTER | 1 | 1 | 1 | 1 |
| | | | END | 0.986 | 1.018 | 0.986 | 0.991 |
| SECOND COMPARATIVE EXAMPLE | 0 | 2.5µm | CENTER | 1 | 1 | 1 | 1 |
| | | | END | 1.004 | 0.643 | 0.869 | 0.561 |
| | | | | | | | |

| | THICKNESS | | POSITION | OPEN VOLATAGE Voc(V) | SHORT-CIRCUITING CURRENT DENSITY Jsc (mA/cm²) | FF | EFFICIENCY η (%) |
|---|---|---|---|---|---|---|---|
| | SECOND i-TYPE LAYER 42b | FIRST i-TYPE LAYER 42a | | | | | |
| THIRD COMPARATIVE EXAMPLE | 1.0µm | 1.5µm | CENTER | 1 | 1 | 1 | 1 |
| | | | END | 0.991 | 0.898 | 0.928 | 0.827 |
| FOURTH COMPARATIVE EXAMPLE | 1.5µm | 1.0µm | CENTER | 1 | 1 | 1 | 1 |
| | | | END | 1.002 | 0.912 | 0.947 | 0.865 |

In the first Example, the reductions of the short-circuit current density Jsc and the fill factor FF were small even in a region near the end of the panel plane, and reduction of the efficiency η of the photoelectric conversion for the overall cell was also small compared to the value near the center. In the second Example, the reduction of the short-circuit current density Jsc was greater than the first Example, but the fill factor FF was improved, and reduction of the efficiency η of photoelectric conversion for the overall cell was small compared to the value near the center.

On the other hand, in a configuration where the second i-type layer 42b was not formed and only the first i-type layer 42a was formed, as in the first Comparative Example, the open voltage Voc and the fill factor FF were significantly reduced compared to the value near the center, but the short-circuit current density Jsc was significantly improved, and reduction of the efficiency η of photoelectric conversion for the overall cell was small compared to the value near the center. However, the absolute value of the efficiency η of each cell was significantly reduced compared to the first and second Examples, and the configuration did not satisfy both the improvement of the absolute efficiency η and improved uniformity of the efficiency η within the panel plane.

In a configuration where the first i-type layer 42a was not formed and only the second i-type layer 42b was formed, as in the second Comparative Example, although the open voltage Voc was slightly improved compared to the value near the center, the short-circuit current density Jsc and the fill factor FF were significantly reduced, and as a result, the efficiency η of photoelectric conversion for the overall cell was significantly reduced compared to the value near the center. In this manner, when the first i-type layer 42a was not formed, the uniformity of the efficiency η within the panel plane was not improved.

In a configuration where the order of layering of the first i-type layer 42a and the second i-type layer 42b was reversed, as in the third and fourth Comparative Examples, the short-circuit current density Jsc and the fill factor FF were reduced, and the efficiency η of photoelectric conversion for the overall cell was significantly reduced compared to the value near the center.

It can be deduced that the results as described above were obtained because, with formation of the first i-type layer 42a having a relatively uniform distribution of crystallization percentage Xc in the plane as a base layer, the absolute value of the crystallization percentage Xc of the second i-type layer 42b formed over the first i-type layer 42a was improved while the uniformity of the crystallization percentage Xc of the first i-type layer 42a was maintained.

FIG. 5 shows a result of measurement of the crystallization percentage Xc of the first i-type layer 42a and the crystallization percentage Xc in the state where the second i-type layer 42b is formed over the first i-type layer 42a, measured while the distance from the end is changed on a diagonal line of the panel of the photoelectric conversion device 100. A measurement method was employed in which, after the photoelectric conversion device 100 was formed, a measurement location was cut out, a angle lap was applied in a thickness direction, and crystallization percentage Xc was measured for a region where only the first i-type layer 42a was left and for a region where the second i-type layer 42b was left over the first i-type layer 42a, through Raman spectroscopy. The crystallization percentage Xc was defined by analyzing, through Raman spectroscopy, a Raman spectrum measured using laser light of a wavelength of 514 nm, separating the Raman spectrum into a Raman scattering intensity Ic around 520 cm⁻¹ derived from crystalline silicon and a Raman scattering intensity Ia around 480 cm⁻¹ derived from amorphous silicon, and defining the crystallization percentage Xc as a ratio of the height of the peaks, Ic/Ia.

As shown in FIG. 5, in a region of 5 cm - 11 cm from the panel end, the crystallization percentage Xc of a region with only the first i-type layer 42a (wide line in FIG. 5) was higher than the crystallization percentage Xc (narrow line in FIG. 5) of a region where the second i-type layer 42b was formed over the first i-type layer 42a. In other words, it is possible to judge whether or not the present invention is applied by measuring a change of the crystallization percentage in the thickness direction in the region of 5 cm ∼ 11 cm from the panel end and confirming that the crystallization percentage Xc of the overall i-type layer 40 (in a state where the second i-type layer 42b is formed over the first i-type layer 42a) is smaller than the crystallization percentage Xc of the state where the i-type layer is ground in the thickness direction and only the first i-type layer 42a serving as the base layer is left.

In the present embodiment, a tandem structure of the amorphous silicon photoelectric conversion unit 102 and the microcrystalline silicon photoelectric conversion unit 104 is exemplified, but the present embodiment is not limited to such a configuration, and a single structure of the microcrystalline silicon photoelectric conversion unit 104 may be employed or a layered structure with a photoelectric conversion unit other than the amorphous silicon photoelectric conversion unit 102 or a layered structure of three or more photoelectric conversion units may be employed.

In the above-described embodiment, the first i-type layer 42a and the second i-type layer 42b are formed directly over the p-type layer 40. Here, as shown in FIG. 6, a configuration is employed in which a buffer layer 42c is provided between the p-type layer 40 and the first i-type layer 42a.

The buffer layer 42c is preferably formed by plasma film formation. As the plasma film formation, a VHF plasma film formation of a frequency greater than or equal to 13.56 MHz and less than or equal to 70 MHz is preferably applied. In addition, the substrate temperature during the film formation is preferably greater than or equal to 160 °C and less than or equal to 230 °C, and an introduction power for the plasma is preferably greater than or equal to 0.15 W/cm² and less than or equal to 0.4 W/cm².

A thickness of the buffer layer 42c is preferably greater than or equal to 20 nm and less than or equal to 50 nm. The buffer layer 42c preferably has a crystallization percentage Xc, when the layer is formed as a single film over a glass substrate or the like, which is greater than the crystallization percentages Xc of the first i-type layer 42a and the second i-type layer 42b when the films are formed as single films over the glass substrate or the like. In addition, a distribution of the crystallization percentage Xc within the plane of the substrate when the buffer layer 42c is formed as a single film over a glass substrate or the like is preferably more uniform than the distributions of the crystallization percentages Xc when the first i-type layer 42a and the second i-type layer 42b are formed as single films over the glass substrate or the like.

More specifically, the crystallization percentage Xc of the buffer layer 42c is preferably greater than or equal to 10, and more preferably, greater than or equal to 13. In this case, when the crystallization percentage Xc of the buffer layer 42c is greater than or equal to 10 and less than 13, the thickness of the buffer layer 42c is preferably greater than or equal to 40 nm. In the case where the crystallization percentage Xc of the buffer layer 42c is greater than or equal to 13, the thickness of the buffer layer 42c is not particularly limited, but is preferably greater than or equal to 30 nm.

In the present embodiment, the buffer layer 42c is formed as one of the i-type layers which is not doped, but alternatively, the buffer layer 42c may be doped with a p-type dopant and formed as one of the p-type layers.

### (Third ∼ Fifth Examples)

The transparent insulating substrate 10 and the transparent conductive film 12 were prepared similarly to the first Example. After the transparent conductive film 12 was patterned into a strip shape, similar to the first Example, the p-type layer, the i-type layer, and the n-type layer of the a-Si unit 102 were layered under the conditions shown in Table 1.

The µc-Si unit 104 was formed under conditions shown in Table 4. After the p-type layer 40 was formed over the a-Si unit 102, the buffer layer 42c was formed. Over the buffer layer 42c, similar to the first Example, the first i-type layer 42a, the second i-type layer 42b, and the n-type layer 44 were formed. In Table 4, diborane (B₂H₆) and phosphine (PH₃) are shown with a gas flow rate at a concentration of 1% based on hydrogen.

**[Table 4]**

| | LAYER | SUBSTRATE TEMPERATURE (C°) | GAS FLOW RATE (sccm) | REACTION PRESSURE (Pa) | FREQUENCY | RF power (kW) | DISTANCE BETWEEN ELECTRODES (mm) | THICKNESS (nm) |
|---|---|---|---|---|---|---|---|---|
| µc-Si UUNIT 104 | p-TYPE LAYER 40 | 200 | SiH₄:25 H₂:5000 B₂H₆:5 | 106 | RF | 250 (0.05W/cm²) | 25 | 30 |
| | BUFFER LAYER 42c | 180 | SiH₄:50 H₂:12500 | 700 | VHF (27MHz) | 750 - 2000 (0.15 - 04W /cm²) | 8 | 20-50 |
| | FIRST i-TYPE LAYER 42a | 180 | SiH₄:300 H_{2:}14000 | 9600 | VHF (27MHz) | 2500 (0.5W/cm²) | 6 | 1500 |
| | SECOND i-TYPE LAYER 42a | 180 | SiH₄:300 H₂:14000 | 11000 | VHF (27MHz) | 2500 (0.5W/cm²) | 7 | 1000 |
| | n-TYPE LAYER 44 | 200 | SiH₄:25 H₂:5000 PH_{3:}25 | 133 | RF | 1500 (0.3W/cm²) | 25 | 50 |

The film formation conditions shown in Table 4 are conditions such that the crystallization percentage Xc when the buffer layer 42c is formed as a single film over the glass substrate or the like is higher than the crystallization percentages Xc of the first i-type layer 42a and the second i-type layer 42b when these layers are formed as single films over the glass substrate or the like, and the distribution of the crystallization percentage Xc within the plane of the substrate when the buffer layer 42c is formed as a single film over the glass substrate or the like is more uniform than the distribution of the crystallization percentages Xc when the first i-type layer 42a and the second i-type layer 42b are formed as single films over the glass substrate or the like.

Then, similar to the first Example, the a-Si unit 102 and the µc-Si unit 104 were patterned into a strip shape, and the first backside electrode layer 16 and the second backside electrode layer 18 were formed through sputtering. Then, the first backside electrode layer 16 and the second backside electrode layer 18 were patterned into a strip shape.

A sample in which the buffer layer 42c was formed to a thickness of 40 nm, under a condition that the crystallization percentage Xc (Ic/Ia) when the buffer layer 42c is formed as a single film over the glass substrate or the like was 10, was set as a third Example. Similarly, a sample in which the buffer layer 42c was formed to a thickness of 30 nm, under the condition of the crystallization percentage Xc (Ic/Ia) of 13, was set as a fourth Example, and a sample in which the buffer layer 42c was formed to a thickness of 40 nm, under the condition of the crystallization percentage Xc (Ic/Ia) of 13, was set as a fifth Example. The crystallization percentage Xc of the buffer layer 42c can be adjusted by changing the power to be introduced to the plasma during film formation. The thickness of the first i-type layer 42a was set to 1.5 µm, and the thickness of the second i-type layer 42b was set to 1.0 uµm.

### (Fifth and Sixth Comparative Examples)

A sample in which the buffer layer 42c was formed to a thickness of 30 nm, under a condition that the crystallization percentage Xc (Ic/Ia) when the buffer layer 42c is formed as a single film over the glass substrate or the like was 7, was set as a fifth Comparative Example. A sample in which the buffer layer 42c was formed to a thickness of 30 nm, under a condition that the crystallization percentage Xc (Ic/Ia) was 10, was set as a sixth Comparative Example.

Table 4 and FIG. 7 show a distribution of efficiency η at a position on the substrate plane in the fifth Example. FIG. 7 also shows a result of a comparative example formed under the same conditions as the fifth Example except that the buffer layer 42c was not formed. In addition, the efficiency η is shown with a value normalized by a value at the center of the substrate.

**[Table 5]**

| | EFFICIENCY η (END/CENTER) |
|---|---|
| WITHOUT BUFFER LAYER 42c | 0.85 |
| FIFTH EXAMPLE | 0.99 |

As shown in Table 4 and FIG. 7, in the sample formed without the buffer layer 42c, the efficiency η was reduced at the end of the substrate compared to the center of the substrate to a factor of 0.85. In the fifth Example in which the buffer layer 42c was formed, on the other hand, the efficiency η at the end of the substrate was 0.99 times the efficiency at the center of the substrate, and there was almost no reduction.

Table 6 and FIG. 8 show a result of measurement of the efficiency η of the end of the substrate for the fifth and sixth Comparative Examples and the third through fifth Examples. In Table 6 and FIG. 8 also, similar to FIG. 7, the efficiency η is shown with a value normalized by a value at a center of the substrate.

**[Table 6]**

| | CRYSTALLIZATION PERCENTAGE Xc (Ic/Ia) | THICKNESS | EFFICIENCY η (END/CENTER) |
|---|---|---|---|
| FIRST COMPARATIVE EXAMPLE | 7 | 30 | 0.542 |
| SECOND COMPARATIVE EXAMPLE | 10 | 30 | 0.330 |
| THIRD EXAMPLE | 10 | 40 | 0.962 |
| FOURTH EXAMPLE | 13 | 30 | 0.964 |
| FIFTH EXAMPLE | 13 | 40 | 0.985 |

In the samples of third through fifth Examples also, the efficiency η at the end of the substrate was maintained at 0.962 times - 0.985 times the efficiency η at the center of the substrate, and an advantage of reducing the variance of the photoelectric conversion efficiency within the panel plane in the photoelectric conversion device was obtained. On the other hand, in the samples of the fifth and sixth Comparative Examples, the efficiencies η at the end of the substrate were reduced to 0.542 times and 0.330 times the efficiencies at the center of the substrate.

As described, by forming, prior to the formation of the first i-type layer 42a, a buffer layer 42c having a higher crystallization percentage Xc (Ic/Ia) and a higher in-plane distribution than the first i-type layer 42a and the second i-type layer 42b when the layer is formed as a single film over the glass substrate, it is possible to reduce the variance of the photoelectric conversion efficiency within the panel plane in the photoelectric conversion device. The advantage was particularly significant for the buffer layer 42c with the crystallization percentage Xc (Ic/Ia) of greater than or equal to 10 and the thickness of greater than or equal to 40 nm, or for the buffer layer 42c with the crystallization percentage Xc (Ic/Ia) of greater than or equal to 13.

### [Explanation of Reference Numerals]

10 TRANSPARENT INSULATING SUBSTRATE; 12 TRANSPARENT CONDUCTIVE FILM; 14 INTERMEDIATE LAYER; 16 FIRST BACKSIDE ELECTRODE LAYER; 18 SECOND BACKSIDE ELECTRODE LAYER; 20 FILLING MEMBER; 22 PROTECTIVE FILM; 40 p-TYPE LAYER; 42 i-TYPE LAYER; 42a FIRST i-TYPE LAYER; 42b SECOND i-TYPE LAYER; 44 n-TYPE LAYER; 100 PHOTOELECTRIC CONVERSION DEVICE; 102 AMORPHOUS SILICON PHOTOELECTRIC CONVERSION UNIT; 104 MICROCRYSTALLINE SILICON PHOTOELECTRIC CONVERSION UNIT

## Claims

1. A method of manufacturing a photoelectric conversion device having a layered structure of a p-type layer, an i-type layer including a microcrystalline silicon layer which serves as a power generating layer, and an n-type layer, the method comprising the step of:
forming the i-type layer wherein a first microcrystalline silicon layer is formed, and a second microcrystalline silicon layer is formed over the first microcrystalline silicon layer under a condition that a crystallization percentage is higher than that of the first microcrystalline silicon layer and an in-plane distribution of the crystallization percentage is lower than that of the first microcrystalline silicon layer.

2. The method of manufacturing the photoelectric conversion device according to Claim 1, wherein
the first microcrystalline silicon layer is formed under a condition that, when the first microcrystalline silicon layer is formed as a single film over a glass substrate, a ratio of peak heights Ic/Ia between a Raman scattering intensity Ic around 520 cm⁻¹ in Raman spectroscopy and a Raman scattering intensity Ia around 480 cm⁻¹ is in a range of 2 - 4, and
the second microcrystalline silicon layer is formed under a condition that, when the second microcrystalline silicon layer is formed as a single film over a glass substrate, the ratio of peak heights Ic/Ia is in a range of 4 - 6.

3. The method of manufacturing the photoelectric conversion device according to Claim 1 or 2, further comprising the step of:
forming, prior to the formation of the first microcrystalline silicon layer, a buffer layer under a condition that the crystallization percentage is higher than those of the first microcrystalline silicon layer and the second microcrystalline silicon layer and the in-plane distribution of the crystallization percentage is higher than those of the first microcrystalline silicon layer and the second microcrystalline silicon layer.

4. The method of manufacturing the photoelectric conversion device according to Claim 3, wherein
in the buffer layer, a ratio of peak heights Ic/Ia between a Raman scattering intensity Ic around 520 cm⁻¹ in Raman spectroscopy and a Raman scattering intensity Ia around 480 cm⁻¹ when the buffer layer is formed as a single film over a glass substrate is greater than or equal to 10 and a thickness is greater than or equal to 40 nm, or the ratio of the peak heights Ic/Ia is greater than or equal to 13.

5. A photoelectric conversion device having a layered structure of a p-type layer including a p-type dopant, an i-type layer including a microcrystalline silicon layer which serves as a power generating layer, and an n-type layer including an n-type dopant, wherein
the i-type layer has a layered structure of a first microcrystalline silicon layer and a second microcrystalline silicon layer formed under a condition that a crystallization percentage is higher than that of the first microcrystalline silicon layer and an in-plane distribution of the crystallization percentage is lower than that of the first microcrystalline silicon layer.

6. The photoelectric conversion device according to Claim 5, wherein
the first microcrystalline silicon layer has a thickness within a range of greater than or equal to 100 nm and less than or equal to 2500 nm.

7. The photoelectric conversion device according to Claim 5 or 6, further comprising:
a buffer layer formed under a condition that the crystallization percentage is higher than those of the first microcrystalline silicon layer and the second microcrystalline silicon layer and the in-plane distribution of the crystallization percentage is higher than those of the first microcrystalline silicon layer and the second microcrystalline silicon layer, and
the first microcrystalline silicon layer is formed over the buffer layer.

8. The photoelectric conversion device according to Claim 7, wherein
in the buffer layer, a ratio of peak heights Ic/Ia between a Raman scattering intensity Ic around 520 cm⁻¹ in Raman spectroscopy and a Raman scattering intensity Ia around 480 cm⁻¹ when the buffer layer is formed as a single film over a glass substrate is greater than or equal to 10 and a thickness is greater than or equal to 40 nm, or the ratio of the peak heights Ic/Ia is greater than or equal to 13.
